# EUROPEAN PATENT SPECIFICATION

(11) **EP 4 068 915 B1**
(45) Date of publication and mention of the grant of the patent: **13.05.2026**
(21) Application number: 21166015.4
(22) Date of filing: 30.03.2021
(51) Int. Cl.: H05K 1/18, H01R 12/57, H01R 12/70, H01L 21/48, H01L 23/498, H01L 25/07, H01L 23/373, H01R 12/52, H05K 3/32

(54) **POWER MODULE AND METHOD FOR MANUFACTURING A POWER MODULE**
STROMMODUL UND VERFAHREN ZUR HERSTELLUNG DES STROMMODULS
MODULE DE PUISSANCE ET PROCÉDÉ DE FABRICATION D'UN MODULE DE PUISSANCE

(43) Date of publication of application: 05.10.2022
(73) Proprietor: Hitachi Energy Ltd, 8050 Zürich (CH)
(72) Inventor: Thut, Markus, 2560 Nidau (CH); Truessel, Dominik, 5620 Bremgarten (CH); Ehrbar, Roman, 8037 Zürich (CH); Beyer, Harald, 5600 Lenzburg (CH)
(74) Representative: Epping - Hermann - Fischer

(56) References cited:
- EP-A1- 3 065 164
- CN-A- 110 060 971
- US-A1- 2014 003 016

## Description

The present disclosure relates to a power module and method for manufacturing a power module. The power module can be used in power electronic devices, such as motor drives or power converters in electric vehicles (EV), for example. The power module can be a power semiconductor module. The power module may be a high voltage power module.

Documents CN 105655306 A and CN 110060971 A disclose a power module comprising metal clips for interconnecting substrate metallizations and chips. Alternatively, such connections may be provided by wire bonds. In both cases, separate current carrying terminal members for connecting the power module to the outside are provided. Document EP 3 065 164 A1 discloses a semiconductor arrangment, wherein semiconductor devices are located in two rows at opposite sides of an interposer. Conductive elements are provided to induce a respective current into the power semiconductor arrangment.

Embodiments of the disclosure relate to a power module having an improved connection to the outside and a need for an improved method for manufacturing a power module.

According to a first aspect of the disclosure, a power module comprises several contact portions and a terminal member with a terminal for electrically connecting one or more of the contact portions to the outside. An external contact may be electrically and mechanically connected to the terminal by a screw and bold connection, for example. Other suitable connection methods for mounting an external contact are welding, soldering, gluing and press-fit, for example.

A contact portion may be in the form of a metallization on a substrate or an electrically conducting portion on a surface of an electric component, for example. An electric component may be a chip, for example. The electric component may be located on a metallization on a substrate. The terminal member may interconnect metallizations of one or more substrates. Alternatively or additionally the terminal member may connect electric components to metallizations or may connect electric components to electric components.

The terminal member may be formed as a single piece. The terminal member may be formed from a metal plate. It is also possible that the terminal member comprises or consists of two or more pieced joined together. Each of the two or more pieces may be formed from a metal plate. The pieces may be from materials with different hardness or may have a different thickness. As an example, copper of different hardness may be used.

The terminal may be in the form of a main terminal, i.e., a current carrying terminal, for example. It is also possible that the terminal is an auxiliary terminal for controlling or monitoring purposes. As an example, auxiliary terminals may include signal terminals for controlling switching devices.

The terminal member comprises at least one foot electrically contacting one of the contact portions. The terminal member may comprise at least two feet. At least two of the feet of the terminal member are intermediate feet. Furthermore, at least two of the feet of the terminal member are end feet. While an end foot is free-standing, i.e., connected to only one section of the terminal member, an intermediate foot is located between two sections of the terminal member. Exemplarily, an end foot is connected to a section of the terminal member only at one end, while an intermediate foot is connected to sections of the terminal member at two ends.

As an example, an intermediate foot may be located between the terminal and the end foot. In this case, a current path from the terminal to the end foot leads through the intermediate foot. The intermediate foot is also denoted as a "stitch" and the terminal comprising an intermediate foot is also denoted as a "stitch terminal", in the following.

According to an embodiment, the terminal member may comprise several intermediate feet arranged in series. Accordingly, a current path from the terminal to an end feet runs through all of the serially arranged intermediate feet. The serially arranged intermediate feet may contact several contact portions on at least one of different substrates or the same substrate. It is also possible that the terminal member comprises intermediate feet arranged in series and intermediate feet arranged in parallel. It is also possible that the terminal member comprises two or more parallel parts wherein one or more of the parts only comprises end feet but no intermediate feet and one or more of the parts comprises end feet and intermediate feet.

In an embodiment, the power module comprises several substrates comprising at least some of the contact portions. The substrates may be located on a base plate. The terminal member may contact at least two contact portions of different substrates. Accordingly, the stitch terminal does not only provide a connection to the outside but also an integrated substrate-to-substrate connection.

Alternatively or additionally, the terminal member may connect contact portions of a single substrate. The single substrate may be located on a base plate. The power module may also have the design of an insulated metal substrate. It is also possible that the terminal member both connects several contact portions on one substrate and one or more contact portions on a further substrate. It is also possible that at least some of the contact portions are conducting portions on surfaces of electric components. The electric components may be mounted on metallizations on a substrate.

The terminal member may comprise a bridge located between an intermediate foot and an end foot or located between two intermediate feet. The bridge lifts off from the contact portions. In specific embodiments, the bridge may bridge a gap between different substrates, for example.

According to an embodiment, the power module comprises electric components in form of a first switch element and a second switch element electrically connected to form a half bridge. The terminal member may electrically connect the switch elements. The switch elements can be located on the same substrate or on different substrates. The power module may comprise several further switch elements, which may be also connected by the terminal member. The power module may comprise other passive or discrete components which may be connected by the terminal member.

The terminal member comprises a bar connecting several feet in parallel. The bar connects several end feet in parallel and connects several intermediate feet in parallel. The bar may be oriented parallel to a side face on which the terminal is located, for example. The bar may connect several terminal portions such as intermediate feet and/or end feet arranged in parallel. As an example, the bar may be located between several end feet and several intermediate feet. However, the end feet can also branch off the bar not explicitly parallel, but at any angle compared to the general direction of the terminal.

The power module may comprise further terminal members. As an example, the terminal member described in the foregoing may provide an AC terminal and the further terminals may provide DC+ and DC- terminals. It is also possible that the terminal member provides an auxiliary terminal. The further terminal members may comprise end feet but may be free from intermediate feet, for example. It is also possible that at least one of the further terminal members comprise intermediate feet or both intermediate feet and end feet. One or more of the further terminal members may partially overlap with the terminal member in a height direction. As an example, the further terminal member may comprise a bar overlapping with the bar of the terminal member.

According to a further aspect of the disclosure, a method for manufacturing a power module comprises the step of providing one or more substrates comprising one or more contact portions and providing a terminal member comprising a terminal for electrically connecting the contact portions to the outside. The one or more substrates may comprise power semiconductor devices which may be in the form of chips, for example. The substrates may be located on a base plate. The power module and terminal member may comprise all structural and functional features of the terminal member described in the foregoing. The method comprises the further step of fixing and, thereby, electrically connecting the at least one intermediate foot to one of the contact portions. Exemplarily, the terminal member may comprise at least one intermediate foot and at least one end foot, wherein each of the intermediate foot and the end foot are connected to different ones of the contact portions.

By this method, a connection of contact portions to each other and to the outside can be provided in a single process. The contact portions may be located on different substrates such that an integrated substrate-to-substrate connection is provided. The substrates may be free from an electrical connection to each other before the terminal member is connected to the substrates. Accordingly, separate elements such as wire bonds or clips are not required for connecting the substrates to each other. It is also possible that the contact portions are located on the same substrate and that the terminal member connects the contact portions within the same substrate. The contact portions may be free from an electrical connection to each other before the terminal member is connected. It is also possible that the terminal member both connects contact portion within a substrate and contact portions of different substrates.

According to an embodiment, the feet are connected to the contact portions by welding. As examples, ultrasonic welding, laser welding or resistive welding technologies may be used.

According to an alternative embodiment, the feet are connected to the contact portions by gluing, soldering or sintering.

The present disclosure comprises several aspects and embodiments. Every feature described with respect to one of the aspects and embodiments is also disclosed herein with respect to the other aspects and embodiments, even if the respective feature is not explicitly mentioned in this context.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
Figure 1 is a top view of a power module according to an embodiment,
Figure 2 is a side view of the power module of Figure 1,
Figure 3 is a perspective view of a terminal member for a power module according to an embodiment,
Figure 4 is a schematic view of a power module according to a further embodiment,
Figure 5 is a top view of a power module according to a further embodiment,
Figure 6 is a side view of the power module of Figure 5,
Figures 7A and 7B schematically show steps in a method of manufacturing a power module.

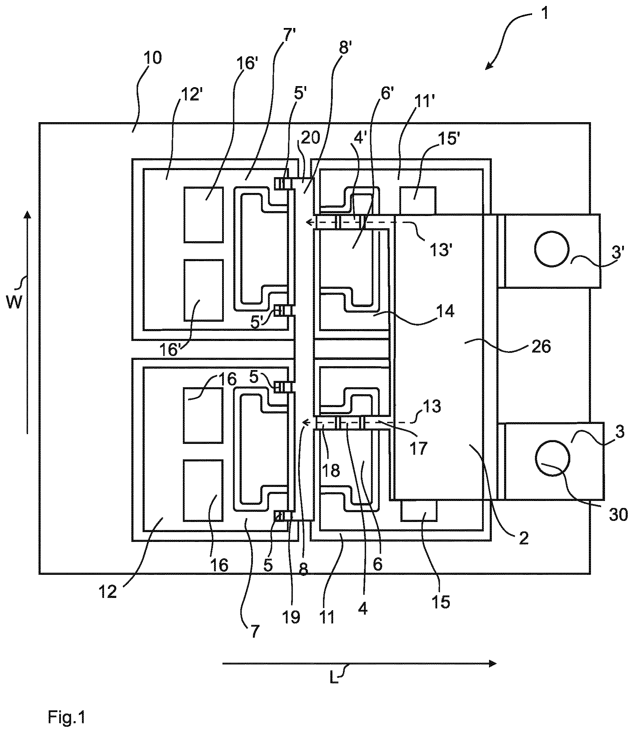

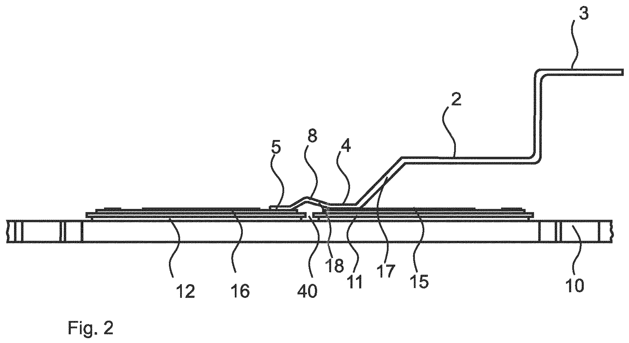

Figure 1 shows a top view of an embodiment of a power module 1 comprising a terminal member 2 for electrically connecting the power module 1 to the outside. Figure 2 shows a side view of the power module 1.

The terminal member 2 has one or more terminals 3, 3' for connecting external contacts. Each of the terminals 3, 3' comprises a hole 30 for fixation of an external contact by a screw and bolt connection, for example. Depending on the layout, the hole 30 may not be present and another connection method such as welding, soldering, gluing or press-fit can be used. The terminal member 2 is formed from a metal plate and can be of a single piece. It is also possible that the terminal member 2 is formed from several pieces connected to each other.

The terminal member 2 may be a current carrying terminal member. The terminal member 2 may provide an AC terminal, for example. Depending on the layout of the module 1, the terminal member 2 may alternatively provide a DC+ or DC-terminal. It is also possible that the terminal member 2 provides an auxiliary terminal for controlling or monitoring purposes, for example. As an example, auxiliary terminals may include signal terminals for controlling switching device, for example.

The terminal member 2 comprises several feet in the form of intermediate feet 4, 4' and end feet 5, 5' electrically and mechanically contacting contact portions 6, 6', 7, 7'. The feet 4, 4', 5, 5' may be connected to the contact portions 6, 6', 7 7' by welding, sintering, soldering or gluing, for example. The terminal member 2 comprises two parallel intermediate feet 4, 4' located in current paths 13, 13' leading to end feet 5, 5'. The contact portions 6, 6', 7, 7' may be metallization on one or more substrates 11, 11', 12, 12'. It is also possible that the contact portions are electrical contacts on surfaces of electric components, such as chips, for example.

Each of the intermediate feet 4, 4' goes over into a bridge 8, 8' which lifts-off from the contact portions 6, 6'. The bridges 8, 8' lead to four parallel end feet 5, 5' which contact further contact portions 7, 7'.

While the end feet 5, 5' are free-standing, i.e., connected to only one section 19 of the terminal member 2 only at one end, the intermediate feet 4, 4' are located between two sections 17, 18 of the terminal member 2 such that both ends are connected to the sections 17, 18, thus, are not free-standing. A current path to another end foot does not lead through an end foot.

The shown terminal member 2 comprising at least one intermediate foot 4, 4' is also called "stitched terminal", in the following. The intermediate foot 4, 4' is also called "stitch", in the following. The stitched terminal member 2 provides not only a connection to a terminal 3 for an outside connection of the power module 1 but also provides an integrated connection between different contact portions 6, 6', 7, 7' due to the presence of several feet, such as intermediate feet 4, 4' and end feet 5, 5'.

In the shown embodiment, the power module 1 comprises a base plate 10, on which several substrates 11, 11', 12, 12' are located. The substrates 11, 11', 12, 12' may be fixed to the base plate 10 by soldering or might be integral parts of a hybrid baseplate assembly, for example. As an example, an insulated metal substrate (IMS) setup may be provided instead. In such a setup, a metal base with an isolating resin sheet and circuit metallizations may be provided.

The terminal member 2 provides an integrated electrical path to the different substrates 11, 11', 12, 12'. The terminal member 2 does not only provide a connection to the outside but also connects the different substrates 11, 11', 12, 12'. In this case, wire bonds for connecting contact portions 6, 6', 7, 7' of different substrates 11, 11', 12, 12' or for connecting contact portions of a single substrate may be not required anymore. Thereby, the outer dimensions of the module 1 can be reduced and manufacturing can be simplified.

On each of the substrates 11, 11', 12, 12', one or more electrical components 15, 15', 16, 16' are located. The electrical components 15, 15', 16, 16' may be in the form of switch elements such as IGBTs (insulated gate bridge transistors) or MOSFETs, for example. For each switch element an associated diode may be located on the same substrate 11, 11', 12, 12'. In embodiments, e.g. for silicon carbide power MOSFETs, diodes may not be required. The diodes may be FWDs (free-wheeling diodes), for example, and may be connected in parallel to the associated switch element. The electrical components 15, 15', 16, 16' may be connected to the contact portions 6, 6', 7, 7' by wire bonds, for example.

The switch elements may be electrically connected in form of a half bridge. A half bridge is an electric circuit comprising two switches connected in series between a DC+ and DC- terminal, wherein an AC terminal, being an output terminal, is connected between the switches. Each one of the switches may comprise several switch elements connected in parallel.

The switch elements at the right may be connected to a DC+ terminal (high side) and the switch elements at the left may be connected to a DC- terminal (low side), for example. The terminal member 2 may be used as an AC terminal connecting the substrates 11, 11', 12, 12' of different sides. In particular, each of the intermediate feet 4, 4' contacts a contact portion 6, 6' on the high side and the end foot 8 contacts a contact portion 7, 7' on the low side. More specifically, the end feet 5, 5' may be electrically connected to the collectors or drains of the low side switches 16, 16' and the intermediate feet 4, 4' may be electrically connected to the emitters or sources of the high side switches. The high side switch elements are connected in parallel to each other. Likewise, the low side switch elements are connected in parallel to each other.

The terminal member 2 provides a connection of different contact portions 6, 6', 7, 7' and different substrates 11, 11', 12, 12' along a length direction L, i.e., a direction from a side of the power module 1 on which the terminals 3, 3' are located to an opposite side of the power module 1. The contact portions 6, 6' are connected electrically in series with the contact portions 7, 7'.

In addition to that, the terminal member 2 provides a connection of different contact portions 6, 6', 7, 7' and different substrates 11, 11', 12, 12' along a width direction W, being perpendicular to a length direction L. This is achieved by several parallel intermediate feet 4, 4' and parallel end feet 5, 5'. It is also possible that the terminal member changes its direction, e.g., makes a curve by 90°. This can be the case when the contact portions are not arranged along a straight line or when the terminal 3 is to be provided at a different side. For this aim, the terminal member 2 comprises a bar 20 from which several end feet 5, 5' extend in one direction and from which several intermediate feet 4, 4' extend in the other direction. It is also possible that one or more end feet extend in the same direction as one or more intermediate feet. In general, parallel intermediate feet 4, 4' and parallel end feet 5, 5' are connected electrically in parallel and can be also geometrically arranged in parallel. However, feet 4, 4', 5, 5' may branch off the bar 20 in any direction and need not be arranged geometrically in parallel.

The bar 20 serves for distributing current and for current homogenization. Exemplarily, the contact portions 6', 7' are electrically connected in parallel to the contact portions 6, 7. In addition to that, the bar 20 may provide mechanical stabilization. Also thermal stress reduction may be provided by the bar 20. The bar 20 which connects several intermediate feet 4, 4' and end feet 5, 5' helps to control the tolerances of the different positions of the feet 4, 4', 5, 5' and stabilizes the feet during the connection process such as welding and soldering, for example.

The terminal member 2 comprises a cut-out 14 delimited by the intermediate feet 4, 4' at opposite sides. Furthermore, the terminal member 2 comprises a connection portion 26 connecting the feet 4, 4', 5, 5' to the terminals 3, 3'. The connection portion 26 may have a larger width in the width direction than each of the feet 4, 4', 5, 5'. The terminal member 2 may be at least partly embedded in a plastic housing by an injection molding process.

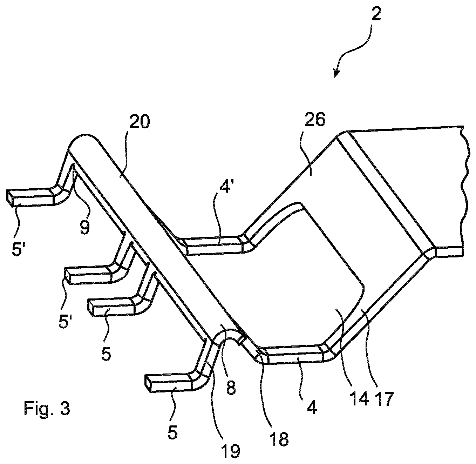

Figure 3 shows a perspective view of a terminal member 2. The geometry of end feet 5, 5' and bridging bar 20 corresponds to the geometry of the embodiments of Figures 1 and 2.

Also the geometry of the intermediate feet 4, 4' corresponds to the geometry of the embodiment of Figures 1 and 2, with a swapped position of the feet 4, 4' in width direction W. In difference to Figures 1 and 2, a plate-shaped connection portion 26 between the intermediate feet 4, 4' and the terminal 3 has a smaller width than the bar 20. In particular, the connection portion 26 does not extend in a width direction beyond the feet 4, 4'. Thereby, space for further elements is available.

The bar 20 may comprise additional stress relief features such as a local reduction of its cross section, for example. Exemplarily, also the sections 17, 18, 19 adjoining the feet 5' may comprise such stress relief features 9.

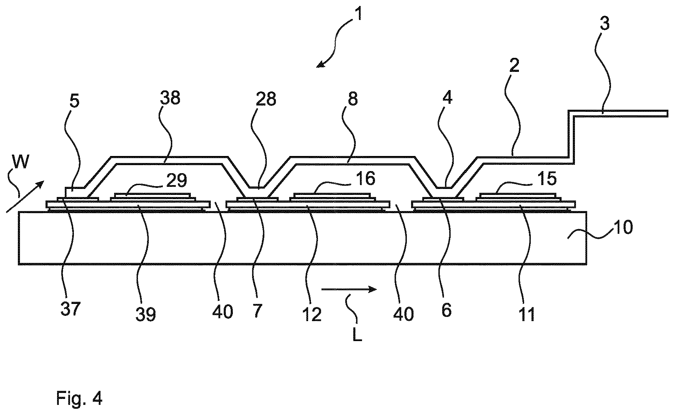

Figure 4 schematically shows a side view of a power module 1 according to a further embodiment.

In this embodiment, the terminal member 2 comprises several intermediate feet 4, 28 connected in series. Accordingly, the intermediate feet 4, 28 are located at different positions along the length direction L. A current path from the terminal 3 to an end foot 5 leads through both intermediate feet 4, 28. The power module 1 comprises three substrates 11, 12, 39 in a row along the length direction L. The feet 4, 28, 5 connect contact portions 6, 7, 37 on the substrates 11, 12, 39. The terminal member 2 comprises bridges 8, 38 for bridging parts of the substrates 11, 12, 39 including electrical components 15, 16, 29 and gaps 40 between the substrates 11, 12, 39.

The feet 4, 28, 5 may connect several switch elements of one side, for example. It is also possible that the switch elements belong to different sides.

Depending on the layout, the feet 4, 28, 5 can be located at the same position along the width direction W or at different positions along the width direction W. It is also possible that the power module 1 additionally comprises further rows of substrates along a width direction connected by further intermediate feet and end feet arranged in parallel to the feet 4, 28, 5. It is also possible that the feet are electrically connected in parallel but are not geometrically arranged in parallel but are oriented at an angle in respect to each other. The bridges 8, 38 can be formed as a bar 20 as shown in Figure 3.

In the shown embodiment, two intermediate feet 4, 28 are connected in series. It is also possible that more than two intermediate feet 4, 28 are connected in series. Furthermore, in the shown embodiment, the power module 1 comprises three substrates 11, 12, 39 in a row along the length direction L. It is also possible that the power module 1 comprises only a single substrate. The intermediate feet 4, 28 and the end foot 5 may connect contact portions located on the same substrate, for example. For this aim, the feet 4, 5, 28 may branch off the terminal member 2 at suitable angles and may not be arranged geometrically in parallel to each other.

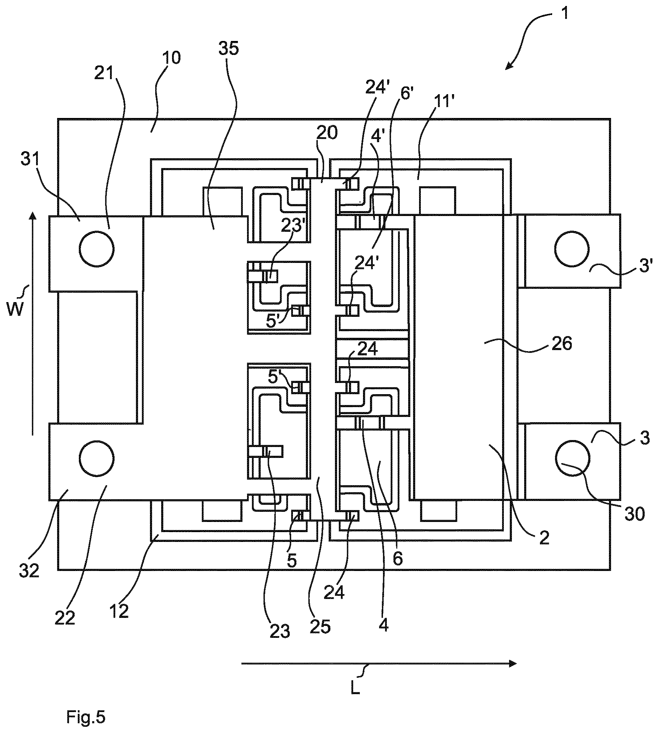

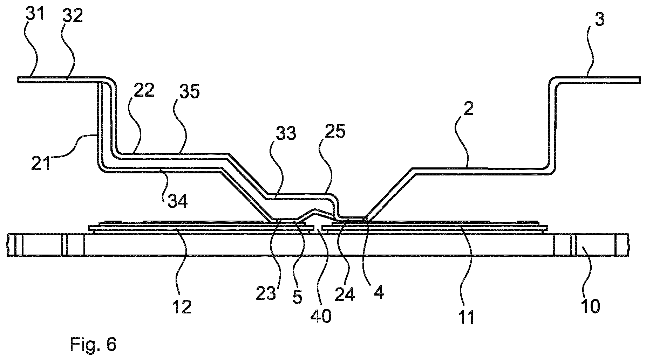

Figures 5 and 6 show a top view and a side view of a power module 1 corresponding to the power module 1 of Figures 1 and 2 with additional further terminal members 21, 22. The further terminal members 21, 22 comprise further terminals 31, 32 for outside connection. The further terminals 31, 32 may be located at a side opposite to the terminals 3, 3'. The further terminal members 21, 22 may be configured for DC- and DC+ connection, respectively. One of the further terminal members 22 also comprises a further bar 25 from which further end feet 24 extend. The further bar 25 overlaps with the bar 20 of the terminal member 2. The further bar 25 is located over the gap 40 between the substrates 12, 12' and the substrates 11, 11'. The further bar 25 is connected by connecting webs 33 to a further connecting portion 34. The other one of the further terminal members 21 comprises further end feet 23 connected to a further connecting portion 35. In the shown embodiment, the further terminal members 21, 22 do not comprise any intermediate feet. In alternative embodiments, depending on the layout of the power module, also further terminal members may comprise intermediate feet.

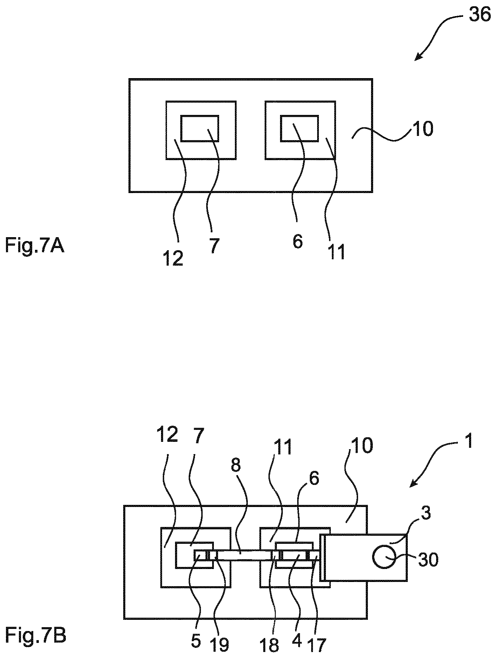

Figures 7A and 7B schematically show method steps for manufacturing a power module 1.

According to a first method step shown in Figure 7A, an assembly 36 comprising a base plate 10 and several substrates 11, 12 on the base plate 10 is provided. The substrates 11, 12 are fixed to the base plate 10 by a solder connection, for example. Electric components (not depicted) such as switches and diodes may be located on the substrates 11, 12. Furthermore, contact portions 6, 7 are provided on the substrates 6, 7.

In this step, the substrates 11, 12 may be not electrically connected to each other. It is also possible that only some of the substrates are electrically connected to each other in this step. As an example, when several substrates are arranged in parallel and in series, substrates arranged in parallel may be electrically connected to each other and substrates arranged in series may not be electrically connected to each other in this step. It is also possible that contact portions 6, 7 are provided on a single substrate mounted on a base plate or an integrated insulated metal substrate setup may be provided.

In a second step shown in Figure 7B, a terminal member 2 in the form of a metal plate is connected to the contact portions 6, 7 on the substrates 11, 12. The connection is made by a welding process, such as ultrasonic welding, laser welding or resistive welding, for example. It is also possible to fix the terminal member 2 by other methods such as soldering, sintering or gluing, for example. The power module 1 shown in Figure 7B is a further embodiment.

The terminal member 2 may provide a terminal 3 in the form of a current carrying main terminal. It is also possible that the terminal member 2 provides a terminal 3 in the form of an auxiliary terminal. It is also possible that auxiliary connections are connected to the terminal member 2. After connecting the terminal member 2 to the substrates 11, 12, the terminal member 2 can be at least partly embedded in a plastic housing by an injection or transfer molding process, for example. The terminal member 2 may be partly embedded before or after connecting the terminal member 2 to the contact portions 6, 7. In the first case, the terminal member 2 may be provided as a kind of terminal block.

In all embodiments, the terminal member may not only provide the connection to the outside but also provides an integrated connection between the contact portions such that additional electrical connections such as wire bonds or clips are not required. As an example, the terminal member may provide at least one of a connection of contact portions of different substrates and a connection of contact portions of one substrate. It is also possible that the terminal member provides at least one connection of contact portions of different substrates and at least one connection of contact portions of the same substrate. The contact portions may be at least one of contact portions on substrates or contact portions on surfaces of electric components such as chips. The electric components may be located on metallizations on a substrate.

The integrated connection by the terminal member lowers the costs and shortens the production time of the power module. In addition to that, extra space for an additional substrate-to-substrate connection is not required anymore such that the overall area on the substrates that can be used for power semiconductor dies is increased. Accordingly, compared to separate substrate-to-substrate connections in addition to terminal members, the current rating of the power module can be increased. Additionally, at least in some embodiments, no additional wire bond process after mounting of substrates to a baseplate is needed, whereas only a minor number of additional connections such as welding connections have to be provided.

It has to be understood that the disclosure is not restricted to the specific embodiments shown in the Figures. As shown in Figure 7B, for example, instead of four substrates only two substrates may be present. It is also possible that the terminal member provides a connection of contact portions on a single substrate. The substrates can be arranged in rows and columns or only in a single row, for example. It is also possible that the substrates are arranged in a different form than rows and/or columns. Furthermore, it is also possible that the terminal member connects only some of the substrates but not all substrates on the baseplate.

Furthermore, the terminal member may comprise any number of intermediate feet. The intermediate feet may be arranged in parallel or in series, for example. As an example, the terminal member may comprise only a single intermediate foot and a single end foot, for example. It is also possible that the terminal member comprises more intermediate feet than end feet or vice versa.

The arrangement of terminals could also be flipped by 90°, for example. It is also possible that terminals are located on all sides of the module. As an example, terminals may be configured as at least one of main terminals and auxiliary terminals.

Generally, at least some of the contact portions may be in the form of metallizations on one or more substrates. At least some of the contact portions may be contact portions on surfaces of electric components such as chips.

Furthermore, it is also possible that only one substrate is present. In this case, the terminal member may interconnect contact portions on the single substrate. It is also possible that several substrates are present without that a base plate is provided. It is also possible that at least some of the contact portions are provided on a base plate, e.g. in an insulated metal substrate setup.

### Reference Signs

- 1: power module
- 2: terminal member
- 3, 3': terminal
- 4, 4': intermediate foot
- 5, 5': end foot
- 6, 6': contact portion
- 7, 7': contact portion
- 8, 8': bridge
- 9: stress relief feature
- 10: base plate
- 11, 11': substrate
- 12, 12': substrate
- 13, 13': current path
- 14: cutout
- 15, 15': electric component
- 16, 16': electric component
- 17: section
- 18: section
- 19: section
- 20: bar
- 21, 22: further terminal member
- 23: further end foot
- 24: further end foot
- 25: further bar
- 26: connection portion
- 28: intermediate foot
- 29: electrical component
- 30: hole
- 31: further terminal
- 32: further terminal
- 33: connecting web
- 34: further connecting portion
- 35: further connecting portion
- 36: assembly
- 37: contact portion
- 38: bridge
- 39: substrate
- 40: gap

- L: length direction
- W: width direction

## Claims

1. A power module (1) comprising
several contact portions (6, 6', 7, 7', 37) and a terminal member (2) with a terminal (3, 3') for electrically connecting one or more of the contact portions (6, 6', 7, 7', 37) to the outside,
wherein the terminal member (2) comprises several sections (17, 18, 19) and at least one intermediate foot (4, 4', 28) contacting one of the contact portions (6, 6', 7, 7', 37), wherein the intermediate foot (4, 4', 28) is located between two of the sections (17, 18, 19),
wherein the terminal member (2) comprises at least one end foot (5, 5') connected to only one of the sections (17, 18, 19) of the terminal member (2), wherein a current path from the terminal (3, 3') to the end foot (5, 5') leads through the intermediate foot (4, 4'),
wherein the terminal member comprises a bar (20) from which several end feet (5, 5') extend in one direction and several intermediate feet (4, 4') extend in an opposite direction, wherein the bar (20) connects the end feet (5, 5') in parallel and connects the intermediate feet (4, 4') in parallel.

2. The power module of claim 1,
wherein the terminal member (2) comprises a connection portion (26) connecting the feet (4, 4') to the terminals (3, 3'), the connection portion (26) having a larger width than each of the feet (4, 4').

3. The power module (1) of any of the preceding claims,
wherein the contact portions (6, 6', 7, 7', 37) comprise at least one of metallizations on one or more substrates (6, 6', 7, 7', 37) and contact portions on surfaces of electric components (15, 15', 16, 16').

4. The power module (1) of any of the preceding claims,
comprising one or more substrates (11, 11', 12, 12', 39), wherein at least two of the contact portions (6, 6', 7, 7', 37) are located on the same one of the substrates (11, 11', 12, 12', 39), wherein the terminal member (2) contacts at least the two of the contact portions (6, 6', 7, 7', 37).

5. The power module (1) of any of the preceding claims,
comprising several substrates (11, 11', 12, 12', 39), wherein at least two of the contact portions (6, 6', 7, 7', 37) are located on different ones of the substrates (11, 11', 12, 12', 39), wherein the terminal member (2) contacts at least the two of the contact portions (6, 6', 7, 7', 37).

6. The power module (1) of any of claim 4 and 5,
wherein the terminal member (2) both connects contact portions (6, 6', 7, 7', 37) within a substrate (11, 11', 12, 12', 39) and contact portions 6, 6', 7, 7', 37) of different substrates 11, 11', 12, 12', 39).

7. The power module (1) of any of the preceding claims,
comprising a first electric component (15, 15') in the form of a first switch element and a second electric component (16, 16') in the form of a second switch element, wherein the first switch element and second switch element are electrically connected to form a half bridge, wherein the terminal member (2) electrically connects the first switch element and the second switch element.

8. The power module (1) of claim 7,
comprising several first switch elements and several second switch elements, wherein the first switch elements are high side switch elements and the second switch elements are low side switch elements, wherein each of the intermediate feet (4, 4') is connected to an emitter or source of the high side switch elements and wherein each of the end feet (5, 5') is connected to collectors or drains of the low side switch elements.

9. The power module (1) of any of the preceding claims, wherein the terminal member (2) is a single-piece metal plate.

10. The power module (1) of any of the preceding claims, wherein the terminal member (2) comprises at least two intermediate feet (4, 4', 28) electrically connected in series.

11. The power module (1) of any of the preceding claims, wherein the terminal (3, 3') is at least one of a DC+, DC-, AC terminal and an auxiliary terminal for at least one of controlling or monitoring purposes.

12. The power module (1) of any of the preceding claims, comprising at least one further terminal member (21, 22) at least partly overlapping in a height direction with the terminal member (2).

13. The power module (1) of claim 12,
wherein the further terminal member (21, 22) comprises a further bar (25) and further end feet (5, 5') extending from the further bar (25), wherein the further bar (25) overlaps with the bar (20) in a height direction and wherein the end feet (4, 4') and further end feet (5, 5') extend in different directions seen from the overlapping bar (20) and further bar (25).

14. A method for manufacturing a power module (1), comprising the steps of
A) providing one or more substrates (11, 11', 12, 12', 39) comprising contact portions (6, 6', 7, 7', 37) and providing a terminal member (2) comprising a terminal (3, 3') for electrically connecting the contact portions (6, 6', 7, 7', 37) to the outside, wherein the terminal member (2) comprises at least one intermediate foot (4, 4', 28) contacting one of the contact portions (6, 6', 7, 7', 37),
wherein the at least one intermediate foot (4, 4', 28) is located between two sections (17, 18, 19) of the terminal member (2), wherein the terminal member (2) comprises at least one end foot (5, 5') connected to only one of the sections (17, 18, 19) of the terminal member (2), wherein a current path from the terminal (3, 3') to the end foot (5, 5') leads through the intermediate foot (4, 4'),
wherein the terminal member comprises a bar (20) from which several end feet (5, 5') extend in one direction and several intermediate feet (4, 4') extend in an opposite direction, wherein the bar (20) connects the end feet (5, 5') in parallel and connects the intermediate feet (4, 4') in parallel
B) mechanically and electrically connecting each of the intermediate feet (4, 4', 28) and end feet (5, 5') to one of the contact portions (6, 6', 7, 7', 37).

15. The method of claim 14,
wherein the at least one intermediate foot (4, 4', 28) is connected to the contact portions (6, 6', 7, 7', 37) by welding.

## Patentansprüche

1. Leistungsmodul (1), aufweisend:
mehrere Kontaktabschnitte (6, 6', 7, 7', 37) und ein Anschlusselement (2) mit einem Anschluss (3, 3') zum elektrischen Verbinden eines oder mehrerer der Kontaktabschnitte (6, 6', 7, 7', 37) nach außen,
wobei das Anschlusselement (2) mehrere Abschnitte (17, 18, 19) und mindestens einen Zwischenfuß (4, 4', 28) aufweist, der einen der Kontaktabschnitte (6, 6', 7, 7', 37) kontaktiert, wobei sich der Zwischenfuß (4, 4', 28) zwischen zwei der Abschnitte (17, 18, 19) befindet,
wobei das Anschlusselement (2) mindestens einen Endfuß (5, 5') aufweist, der mit nur einem der Abschnitte (17, 18, 19) des Anschlusselements (2) verbunden ist, wobei ein Strompfad von dem Anschluss (3, 3') zu dem Endfuß (5, 5') durch den Zwischenfuß (4, 4') führt,
wobei das Anschlusselement einen Steg (20) aufweist, von dem mehrere Endfüße (5, 5') in einer Richtung und mehrere Zwischenfüße (4, 4') in einer entgegengesetzten Richtung ausgehen, wobei der Steg (20) die Endfüße (5, 5') parallel verbindet und die Zwischenfüße (4, 4') parallel verbindet.

2. Leistungsmodul nach Anspruch 1,
wobei das Anschlusselement (2) einen Verbindungsabschnitt (26) aufweist, der die Füße (4, 4') mit den Anschlüssen (3, 3') verbindet, wobei der Verbindungsabschnitt (26) eine größere Breite als jeder der Füße (4, 4') aufweist.

3. Leistungsmodul (1) nach einem der vorhergehenden Ansprüche,
wobei die Kontaktabschnitte (6, 6', 7, 7', 37) Metallisierungen auf einem oder mehreren Substraten (6, 6', 7, 7', 37) und/oder Kontaktabschnitte auf Oberflächen elektrischer Komponenten (15, 15', 16, 16') aufweisen.

4. Leistungsmodul (1) nach einem der vorhergehenden Ansprüche,
aufweisend ein oder mehrere Substrate (11, 11', 12, 12', 39), wobei sich mindestens zwei der Kontaktabschnitte (6, 6', 7, 7', 37) auf demselben der Substrate (11, 11', 12, 12', 39) befinden, wobei das Anschlusselement (2) mindestens die zwei der Kontaktabschnitte (6, 6', 7, 7', 37) kontaktiert.

5. Leistungsmodul (1) nach einem der vorhergehenden Ansprüche,
aufweisend mehrere Substrate (11, 11', 12, 12', 39), wobei sich mindestens zwei der Kontaktabschnitte (6, 6', 7, 7', 37) auf verschiedenen der Substrate (11, 11', 12, 12', 39) befinden, wobei das Anschlusselement (2) mindestens die zwei der Kontaktabschnitte (6, 6', 7, 7', 37) kontaktiert.

6. Leistungsmodul (1) nach einem der Ansprüche 4 und 5,
wobei das Anschlusselement (2) sowohl Kontaktabschnitte (6, 6', 7, 7', 37) innerhalb eines Substrats (11, 11', 12, 12', 39) als auch Kontaktabschnitte (6, 6', 7, 7', 37) verschiedener Substrate (11, 11', 12, 12', 39) verbindet.

7. Leistungsmodul (1) nach einem der vorhergehenden Ansprüche,
aufweisend ein erstes elektrisches Bauteil (15, 15') in Form eines ersten Schaltelements und ein zweites elektrisches Bauteil (16, 16') in Form eines zweiten Schaltelements, wobei das erste Schaltelement und das zweite Schaltelement elektrisch verbunden sind, um eine Halbbrücke zu bilden, wobei das Anschlusselement (2) das erste Schaltelement und das zweite Schaltelement elektrisch verbindet.

8. Leistungsmodul (1) nach Anspruch 7,
aufweisend mehrere erste Schaltelemente und mehrere zweite Schaltelemente, wobei die ersten Schaltelemente High-Side-Schaltelemente und die zweiten Schaltelemente Low-Side-Schaltelemente sind, wobei jeder der Zwischenfüße (4, 4') mit einem Emitter oder einer Source der High-Side-Schaltelemente verbunden ist und wobei jeder der Endfüße (5, 5') mit Kollektoren oder Drains der Low-Side-Schaltelemente verbunden ist.

9. Leistungsmodul (1) nach einem der vorhergehenden Ansprüche,
wobei das Anschlusselement (2) eine einstückige Metallplatte ist.

10. Leistungsmodul (1) nach einem der vorhergehenden Ansprüche,
wobei das Anschlusselement (2) mindestens zwei Zwischenfüße (4, 4', 28) aufweist, die elektrisch in Reihe geschaltet sind.

11. Leistungsmodul (1) nach einem der vorhergehenden Ansprüche,
wobei der Anschluss (3, 3') ein DC+, DC-, AC Anschluss und/oder ein Hilfsanschluss für Steuerungs- und/oder Überwachungszwecke ist.

12. Leistungsmodul (1) nach einem der vorhergehenden Ansprüche,
aufweisend mindestens ein weiteres Anschlusselement (21, 22), das sich zumindest teilweise in einer Höhenrichtung mit dem Anschlusselement (2) überlappt.

13. Leistungsmodul (1) nach Anspruch 12,
wobei das weitere Anschlusselement (21, 22) einen weiteren Steg (25) und weitere Endfüße (5, 5') aufweist, die sich von dem weiteren Steg (25) erstrecken, wobei der weitere Steg (25) sich mit dem Steg (20) in einer Höhenrichtung überlappt und wobei sich die Endfüße (4, 4') und weitere Endfüße (5, 5') in unterschiedliche Richtungen erstrecken, gesehen von dem überlappenden Steg (20) und dem weiteren Steg (25).

14. Verfahren zum Herstellen eines Leistungsmoduls (1), aufweisend die Schritte:
A) Bereitstellen eines oder mehrerer Substrate (11, 11', 12, 12', 39), die Kontaktabschnitte (6, 6', 7, 7', 37) aufweisen, und Bereitstellen eines Anschlusselements (2), das einen Anschluss (3, 3') zum elektrischen Verbinden der Kontaktabschnitte (6, 6', 7, 7', 37) mit der Außenseite aufweist, wobei das Anschlusselement (2) mindestens einen Zwischenfuß (4, 4', 28) aufweist, der einen der Kontaktabschnitte (6, 6', 7', 7', 37) kontaktiert,
wobei sich der mindestens eine Zwischenfuß (4, 4', 28) zwischen zwei Abschnitten (17, 18, 19) des Anschlusselements (2) befindet, wobei das Anschlusselement (2) mindestens einen Endfuß (5, 5') aufweist, der mit nur einem der Abschnitte (17, 18, 19) des Anschlusselements (2) verbunden ist, wobei ein Strompfad vom Anschluss (3, 3') zum Endfuß (5, 5') durch den Zwischenfuß (4, 4') führt,
wobei das Anschlusselement einen Steg (20) aufweist, von dem mehrere Endfüße (5, 5') in einer Richtung und mehrere Zwischenfüße (4, 4') in einer entgegengesetzten Richtung ausgehen, wobei der Steg (20) die Endfüße (5, 5') parallel verbindet und die Zwischenfüße (4, 4') parallel verbindet;
B) mechanisches und elektrisches Verbinden der Zwischenfüße (4, 4', 28) und Endfüße (5, 5') mit einem der Kontaktabschnitte (6, 6', 7, 7', 37).

15. Verfahren nach Anspruch 14,
wobei der mindestens eine Zwischenfuß (4, 4', 28) mit den Kontaktabschnitten (6, 6', 7, 7', 37) durch Schweißen verbunden ist.

## Revendications

1. Module de puissance (1) comprenant
plusieurs parties de contact (6, 6', 7, 7', 37) et un organe de borne (2) avec une borne (3, 3') pour connecter électriquement une ou plusieurs des parties de contact (6, 6', 7, 7', 37) à l'extérieur,
dans lequel l'organe de borne (2) comprend plusieurs sections (17, 18, 19) et au moins un pied intermédiaire (4, 4', 28) en contact avec l'une des parties de contact (6, 6', 7, 7', 37), le pied intermédiaire (4, 4', 28) étant situé entre deux des sections (17, 18, 19),
dans lequel l'organe de borne (2) comprend au moins un pied d'extrémité (5, 5') connecté à une seule des sections (17, 18, 19) de l'organe de borne (2), dans lequel un trajet de courant allant de la borne (3, 3') au pied d'extrémité (5, 5') passe par le pied intermédiaire (4, 4'),
dans lequel l'organe de borne comprend une barre (20) à partir de laquelle plusieurs pieds d'extrémité (5, 5') s'étendent dans une direction et plusieurs pieds intermédiaires (4, 4') s'étendent dans une direction opposée, la barre (20) connectant les pieds d'extrémité (5, 5') en parallèle et connectant les pieds intermédiaires (4, 4') en parallèle.

2. Module de puissance selon la revendication 1,
dans lequel l'organe de borne (2) comprend une partie de connexion (26) connectant les pieds (4, 4') aux bornes (3, 3'), la partie de connexion (26) ayant une largeur plus grande que chacun des pieds (4, 4').

3. Module de puissance (1) selon l'une quelconque des revendications précédentes,
dans lequel les parties de contact (6, 6', 7, 7', 37) comprennent au moins un élément parmi des métallisations sur un ou plusieurs substrats (6, 6', 7, 7', 37) et des parties de contact sur des surfaces de composants électriques (15, 15', 16, 16').

4. Module de puissance (1) selon l'une quelconque des revendications précédentes,
comprenant un ou plusieurs substrats (11, 11', 12, 12', 39), dans lequel au moins deux des parties de contact (6, 6', 7, 7', 37) sont situées sur le même substrat parmi les substrats (11, 11', 12, 12', 39), dans lequel l'organe de borne (2) est en contact avec au moins deux des parties de contact (6, 6', 7, 7', 37).

5. Module de puissance (1) selon l'une quelconque des revendications précédentes,
comprenant plusieurs substrats (11, 11', 12, 12', 39), dans lequel au moins deux des parties de contact (6, 6', 7, 7', 37) sont situées sur des substrats différents parmi les substrats (11, 11', 12, 12', 39), dans lequel l'organe de borne (2) est en contact avec au moins deux des parties de contact (6, 6', 7, 7', 37).

6. Module de puissance (1) selon l'une quelconque des revendications 4 et 5,
dans lequel l'organe de borne (2) connecte à la fois des parties de contact (6, 6', 7, 7', 37) à l'intérieur d'un substrat (11, 11', 12, 12', 39) et des parties de contact (6, 6', 7, 7', 37) de substrats (11, 11', 12, 12', 39) différents.

7. Module de puissance (1) selon l'une quelconque des revendications précédentes,
comprenant un premier composant électrique (15, 15') sous la forme d'un premier élément de commutation et un second composant électrique (16, 16') sous la forme d'un second élément de commutation, le premier élément de commutation et le second élément de commutation étant connectés électriquement pour former un demi-pont, dans lequel l'organe de borne (2) connecte électriquement le premier élément de commutation et le second élément de commutation.

8. Module de puissance (1) selon la revendication 7,
comprenant plusieurs premiers éléments de commutation et plusieurs seconds éléments de commutation, les premiers éléments de commutation étant des éléments de commutation côté haut et les seconds éléments de commutation étant des éléments de commutation côté bas, dans lequel chacun des pieds intermédiaires (4, 4') est connecté à un émetteur ou à une source des éléments de commutation côté haut et dans lequel chacun des pieds d'extrémité (5, 5') est connecté à des collecteurs ou à des drains des éléments de commutation côté bas.

9. Module de puissance (1) selon l'une quelconque des revendications précédentes,
dans lequel l'organe de borne (2) est une plaque métallique en une seule pièce.

10. Module de puissance (1) selon l'une quelconque des revendications précédentes,
dans lequel l'organe de borne (2) comprend au moins deux pieds intermédiaires (4, 4', 28) connectés électriquement en série.

11. Module de puissance (1) selon l'une quelconque des revendications précédentes,
dans lequel la borne (3, 3') est au moins une borne parmi une borne CC+, CC-, CA et une borne auxiliaire à des fins de commande et/ou de surveillance.

12. Module de puissance (1) selon l'une quelconque des revendications précédentes,
comprenant au moins un organe de borne (21, 22) supplémentaire chevauchant au moins partiellement l'organe de borne (2) dans une direction de hauteur.

13. Module de puissance (1) selon la revendication 12, dans lequel l'organe de borne (21, 22) supplémentaire comprend une barre (25) supplémentaire et des pieds d'extrémité (5, 5') supplémentaires s'étendant à partir de la barre (25) supplémentaire, la barre (25) supplémentaire chevauchant la barre (20) dans une direction de hauteur et dans lequel les pieds d'extrémité (4, 4') et les pieds d'extrémité (5, 5') supplémentaires s'étendent dans des directions différentes vu à partir de la barre (20) de chevauchement et de la barre (25) supplémentaire.

14. Procédé de fabrication d'un module de puissance (1), comprenant les étapes consistant à
A) fournir un ou plusieurs substrats (11, 11', 12, 12', 39) comprenant des parties de contact (6, 6', 7, 7', 37) et fournir un organe de borne (2) comprenant une borne (3, 3') pour connecter électriquement les parties de contact (6, 6', 7, 7', 37) à l'extérieur, l'organe de borne (2) comprenant au moins un pied intermédiaire (4, 4', 28) en contact avec l'une des parties de contact (6, 6', 7, 7', 37),
dans lequel l'au moins un pied intermédiaire (4, 4', 28) est situé entre deux sections (17, 18, 19) de l'organe de borne (2), l'organe de borne (2) comprenant au moins un pied d'extrémité (5, 5') connecté à une seule des sections (17, 18, 19) de l'organe de borne (2), dans lequel un trajet de courant allant de la borne (3, 3') au pied d'extrémité (5, 5') passe par le pied intermédiaire (4, 4'),
dans lequel l'organe de borne comprend une barre (20) à partir de laquelle plusieurs pieds d'extrémité (5, 5') s'étendent ans une direction et plusieurs pieds intermédiaires (4, 4') s'étendent dans une direction opposée, la barre (20) connectant les pieds d'extrémité (5, 5') en parallèle et connectant les pieds intermédiaires (4, 4') en parallèle
B) connecter mécaniquement et électriquement chacun des pieds intermédiaires (4, 4', 28) et des pieds d'extrémité (5, 5') à l'une des parties de contact (6, 6', 7, 7', 37).

15. Procédé selon la revendication 14,
dans lequel l'au moins un pied intermédiaire (4, 4', 28) est connecté aux parties de contact (6, 6', 7, 7', 37) par soudage.
